# EUROPÄISCHE PATENTSCHRIFT

(11) **EP 1 912 265 B1**
(45) Veröffentlichungstag und Bekanntmachung des Hinweises auf die Patenterteilung: **26.02.2014**
(21) Anmeldenummer: 07115500.6
(22) Anmeldetag: 03.09.2007
(51) Int. Cl.: H01L 41/053, F02M 51/06, H01L 41/083

(54) **Aktormodul mit einem umhüllten Piezoaktor**
Actuator module with a cladded piezo actuator
Module d'actionneur doté d'un piézoactionneur gainé

(30) Priorität: 09.10.2006 DE 102006047607
(43) Veröffentlichungstag der Anmeldung: 16.04.2008
(73) Patentinhaber: ROBERT BOSCH GMBH, 70442 Stuttgart (DE)
(72) Erfinder: Heinz, Rudolf, 71272, Renningen (DE); Kienzler, Dieter, 71229, Leonberg (DE); Schaich, Udo, 70378, Stuttgart (DE)

(56) Entgegenhaltungen:
- EP-A2- 1 901 360
- WO-A1-2006/128749
- WO-A2-2004/006348

## Beschreibung

### Stand der Technik

Die Erfindung betrifft ein Aktormodul mit einem eine Umhüllung aufweisenden Piezoaktor, gemäß der Gattung der Hauptansprüche, der beispielsweise in einem Piezoinjektor zur zeitpunkt- und mengengenauen Dosierung von Kraftstoff in einem Verbrennungsmotor eingesetzt werden kann.

Ein solcher Piezoinjektor besteht im Wesentlichen aus einem Haltekörper und dem im Haltekörper angeordneten Piezoaktor, der zwischen einem Aktorkopf und einem Aktorfuß angeordnete, übereinandergestapelte Piezoelemente aufweist, die jeweils aus mit Innenelektroden eingefassten Piezolagen bestehen. Die Piezoelemente sind unter Verwendung eines Materials mit einer geeigneten Kristallstruktur (Piezokeramik) für die Piezolagen so aufgebaut, dass bei Anlage einer äußeren Spannung an die Innenelektroden eine mechanische Reaktion der Piezoelemente erfolgt, die in Abhängigkeit von der Kristallstruktur und der Anlagebereiche der elektrischen Spannung einen Druck oder Zug in eine vorgebbare Richtung darstellt. Der Piezoaktor ist bei einem Piezoinjektor mit einer Düsennadel verbunden, sodass durch Anlegen einer Spannung an die Piezoelemente eine Düsenöffnung freigegeben wird.

In Diesel-Piezoinjektoren werden bei der so genannten direkten Düsennadelsteuerung die Piezoaktoren direkt im Dieselkraftstoff unter Hochdruck betrieben. Zum Schutz der Piezoelemente, beispielsweise im Hinblick auf deren elektrische Isolation, ist es bekannt, den Piezoaktor mit einem dieselfesten Elastomer zu umhüllen. Nachteilig hieran ist, dass hierfür verwendete Elastomere nicht diffusionsfest gegenüber Dieselkraftstoff, Wasser sowie sonstigen Medien im Kraftstoff sind.

Um eine elektrische und mechanische Isolierung des Piezoaktors zu erreichen, wird oft eine zusätzliche Hülse vorgeschlagen. Aus der DE 102 300 32 A1 ist zur Vermeidung der zuvor beschriebenen Nachteile eine Anordnung mit einem Piezoaktor in umströmenden Medien bekannt, bei der die Piezoelemente in einer formveränderlichen Isolationsmasse vergossen sind, die wiederum in einer seitlich und am oberen und unteren Ende gegenüber dem Medium verschlossenen Hülse eingebracht ist.

Diese bekannten Umhüllungen des Piezoaktors bilden, insbesondere dann wenn die äußere Hülse aus einem flexiblen Material gebildet werden soll, an den Anlagebereichen des Aktorkopfs und des Aktorfußes des Piezoaktors, die vorwiegend aus Stahl hergestellt sind, kritische Dichtbereiche. Es besteht bei einer Anwendung in einem Piezoinjektor, bei dem das Aktormodul vom Kraftstoff, zum Beispiel Diesel, unter hohem Druck umströmt wird, insbesondere die Gefahr, dass die Anlagebereiche der Hülse am Aktorkopf und am Aktorfuß des Piezoaktors vom Kraftstoff unterwandert werden und somit die Funktionsfähigkeit des Aktormoduls über seine Lebensdauer nicht gewährleistet ist. Die bekannten Umhüllungen aus Stahl sind nicht hochdruckfest bei einem hier möglichen Flüssigkeitsdruck von ca. 2000 bar.

EP 1901360 A2 offenbart ein Piezoaktormodul, das zwischen einem Aktorkopf und einem Aktorfuß angeordnete Piezoelemente und einen schrumpfenden Schlauch als Umhüllung aufweist, wobei dieser in Anlagebereichen auf dem Aktorkopf und dem Aktorfuß dichtend anliegt und das Piezoaktormodul mindestens einen Pressring außen auf dem Schlauch aufweist, der den Schlauch auf die Anlagebereiche drückt.

### Offenbarung der Erfindung

Die Erfindung geht von einem eingangs beschriebenen Aktormodul mit einem Piezoaktor aus, der zwischen einem Aktorkopf und einem Aktorfuß angeordnete Piezoelemente aufweist. Es ist eine Umhüllung vorhanden, die aus einer mindestens die Piezoelemente umgebenden Elastomerschicht und einer äußeren flüssigkeitsdichten, den Piezoaktor und die Elastomerschicht umschließenden Hülse besteht. Erfindungsgemäß ist die Hülse aus einem unter Temperatureinwirkung schrumpfenden Schlauch gebildet, der in vorteilhafter Weise in Anlagebereichen auf dem Aktorkopf und dem Aktorfuß des Piezoaktors dichtend anliegt und es ist mindestens ein Pressring außen auf dem Schlauch angeordnet, der den Schlauch auf die Anlagebereiche drückt.

Bei einer bevorzugten Anwendung der Erfindung ist der Piezoaktor Bestandteil eines Piezoinjektors für ein Einspritzsystem für Kraftstoff bei einem Verbrennungsmotor, wobei der Kraftstoff die Umhüllung umströmt.

Bei einem Beispiel ist in mindestens einem Anlagebereich mindestens eine Erhöhung oder Vertiefung vorhanden, wobei nach einer Schrumpfung des Schlauchs und dem Aufbringen der Pressringe durch plastische Verformungen im Schlauch an der Erhöhungen oder in der Vertiefung eine dichte und mechanisch feste Verbindung zwischen dem Schlauch und den jeweiligen Anlagebereichen hergestellt ist. Die Erhöhung oder Vertiefung kann dabei am Umfang des Anlagebereichs radial umlaufend sein und/oder einen rechteckigen oder kegelförmigen Querschnitt aufweisen.

Mit den zuvor erwähnten Vertiefungen, die als umlaufende Nuten im Aktorkopf und/oder im Aktorfuß angeordnet sind, wird eine Kammerwirkung für den schrumpfbaren Schlauch erreicht, die ein Fließen und damit eine Entstehung von Undichtigkeiten im Schlauch verhindert. Bei einer Erwärmung des Schlauches werden durch die axiale Dehnung die inneren Flächen der nach außen stehenden Erhöhungen vom Schlauch angepresst und somit eine erhöhte Dichtwirkung erzielt. Hinsichtlich der nutenförmigen Vertiefungen werden die äußeren Flächen stärker angepresst und damit abgedichtet. Bei einer Abkühlung des Schlauches verläuft dieser Effekt umgekehrt, sodass die Erhöhungen an den Außenflächen und die Vertiefungen an den Innenflächen verstärkt abgedichtet werden.

Bei einem ersten Ausführungsbeispiel der Erfindung ist in mindestens einem Anlagebereich mindestens ein Dichtring angeordnet, der umlaufend zwischen dem schrumpfbaren Schlauch und dem Aktorkopf oder dem Aktorfuß angeordnet ist und aus einem Material ist, vorzugsweise ein Viton-O-Ring, das die Dichtwirkung zwischen dem Schlauch und dem Aktorkopf oder dem Aktorfuß erhöht. Durch den ständigen Anpressdruck wird eine elastische Anpressung auch für den Fall erreicht, dass der schrumpfbare Schlauch fließen sollte.

Andererseits kann auch der in mindestens einem Anlagebereich mindestens eine Dichtring so angeordnet sein, dass dieser umlaufend zwischen dem jeweiligen Pressring und dem Schlauch angeordnet ist. Der Dichtring kann dabei auch auf einfache Weise in einer umlaufenden Nut am Kopf- oder Fußteil oder am Pressring angeordnet werden. Ferner kann der Dichtring auch in einer sich axial erstreckenden konvexen Wölbung des Pressrings angeordnet sein. Der mit dieser konvexen Wölbung erreichte Kammereffekt kann auch mit einer entsprechenden Gestaltung des Dichtringes bei allen Ausführungsformen der Erfindung erreicht werden.

Nach einem zweiten Ausführungsbeispiel ist der zuvor erwähnte mindestens eine Dichtring umlaufend auf dem Aktorkopf oder dem Aktorfuß oder umlaufend auf dem Pressring aufvulkanisiert. Hierbei besteht der aufvulkanisierbare Dichtring in vorteilhafter Weise aus einem vulkanisierbaren Elastomer. Die Dichtung im Anlagebereich des schrumpfbaren Schlauches ist bei dieser Ausführung auch bei eventuellen Beschädigungen oder Fehlern im Dichtring absolut dicht und bereitet keine Montageprobleme.

Wenn der Dichtring auf den Pressring aufvulkanisiert wird, so kann vermieden werden, dass eventuell die hohen Temperaturen beim Vulkanisieren ungewollte Maßänderungen oder Oberflächenoxidationen auf dem Kopf- bzw. dem Fußteil verursachen. Diese Beeinflussungen sind am erfindungsgemäßen Pressring unkritisch.

### Kurze Beschreibung der Zeichnungen

Die Erfindung wird nachfolgend anhand der Ausführungsbeispiele der Zeichnungen erläutert. Dabei zeigen:
Figur 1 eine schematische Darstellung eines Piezoinjektors mit einem Aktormodul nach dem Stand der Technik im Längsschnitt,
Figur 2 eine schematische Darstellung eines erfindungsgemäßen Aktormoduls mit Pressringen über einem am Aktorkopf und am Aktorfuß des Piezoaktors anliegenden schrumpfbaren Schlauch als Hülse,
Figur 3 ein Beispiel eines Aktormoduls mit ringförmigen Erhöhungen am Aktorkopf und am Aktorfuß, die in den Schlauch eingreifen,
Figur 4 eine Abwandlung des Aktormoduls nach der Figur 3 mit Erhöhungen, die einen kegelförmigen Querschnitt aufweisen,
Figur 5 ein Beispiel eines Aktormoduls mit ringförmigen Vertiefungen am Aktorkopf und am Aktorfuß, in die der schrumpfbare Schlauch eingreift,
Figur 6 eine Abwandlung des Aktormoduls nach der Figur 5 mit Vertiefungen, die einen kegelförmigen Querschnitt aufweisen,
Figur 7 ein erstes Ausführungsbeispiel des Aktormoduls nach der Figur 2 mit ringförmigen Vertiefungen am Aktorkopf und am Aktorfuß, in die ein Dichtring eingelegt ist,
Figur 8 eine Ausführung des Aktormoduls nach der Figur 2 mit einem Dichtring zwischen dem Pressring und dem Schlauch,
Figur 9 eine Abwandlung der Ausführung des Aktormoduls nach der Figur 8 mit einem Dichtring zwischen einem konvex gewölbten Pressring und dem Schlauch,
Figur 10 ein zweites Ausführungsbeispiel des Aktormoduls nach der Figur 2 mit einem aufvulkanisierten Dichtring zwischen dem Aktorkopf und am Aktorfuß des Piezoaktors und
Figur 11 eine Abwandlung des Aktormoduls nach der Figur 10 mit einem Dichtring zwischen dem Pressring und dem schrumpfbaren Schlauch, der auf den Pressring aufvulkanisiert ist.

### Ausführungsformen der Erfindung

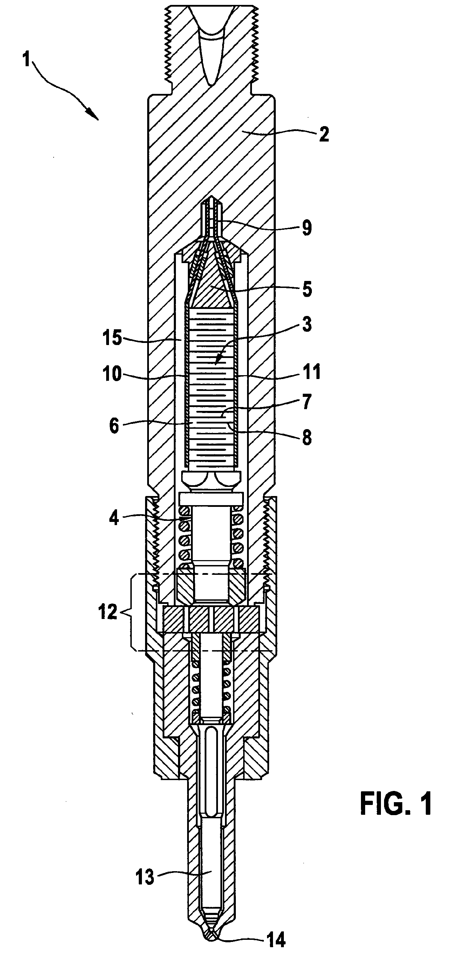

Ein in Figur 1 zur Erläuterung des erfindungemäßen Aktormoduls dargestellter Piezoinjektor 1 nach dem Stand der Technik umfasst im Wesentlichen einen Haltekörper 2 und einen in dem Haltekörper 2 angeordneten Piezoaktor 3, der einen Aktorkopf 4 und einen Aktorfuß 5 aufweist. Es sind dabei zwischen dem Aktorkopf 4 und dem Aktorfuß 5 mehrere übereinandergestapelte Piezoelemente 6 vorhanden, die jeweils aus Piezolagen aus Piezokeramik und diese einschließende Innenelektroden 7 und 8 bestehen.

Die Innenelektroden 7 und 8 der Piezoelemente 6 sind über ein Steckerteil 9 mit Zuleitungen zu Außenelektroden 10 und 11 elektrisch kontaktiert. Der Piezoaktor 3, der mit weiteren, hier nicht näher gezeigten Bauteilen ein sogenanntes Aktormodul darstellt, ist über einen Koppler 12 mit einer Düsennadel 13 verbunden. Durch Anlegen einer Spannung an die Piezoelemente 6 über die Innenelektroden 7 und 8 und die daraus folgende mechanische Reaktion wird, wie in der Beschreibungseinleitung erläutert, eine Düsenöffnung 14 freigegeben. Das Aktormodul mit dem Piezoaktor 3 wird bei der dargestellten Anwendung nach der Figur 1 als Piezoinjektor in einem Raum 15 von dem zu dosierenden Kraftstoff umströmt.

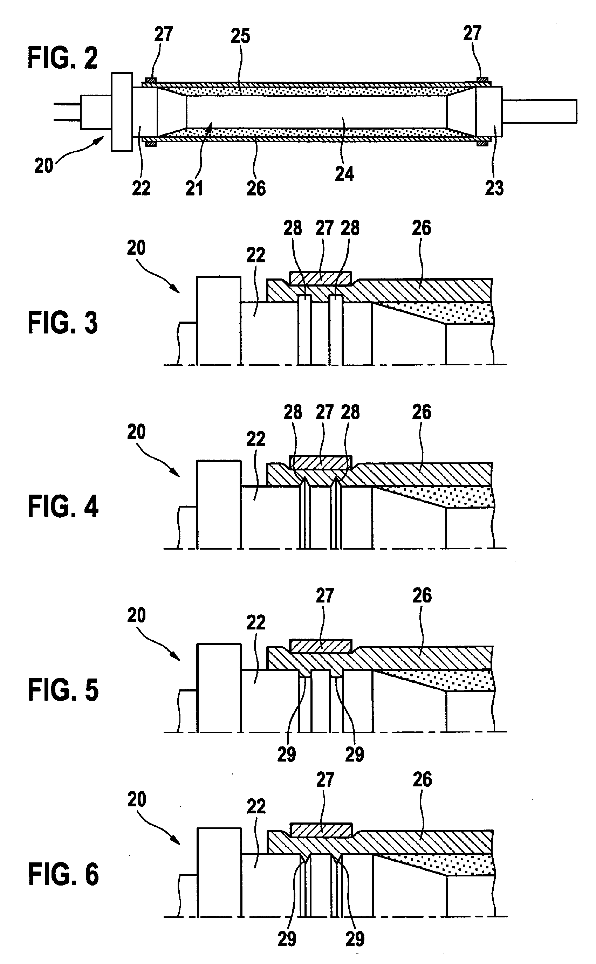

In Figur 2 ist ein erfindungsgemäßes Aktormodul 20 mit einem Piezoaktor 21 als Ausführungsbeispiel dargestellt, der hier vom Aktorkopf 22 zum Aktorfuß 23, einschließlich der hier nicht näher erläuterten Piezoelemente 24, mit einer elektrisch isolierenden Elastomerschicht 25 umgeben ist. Um die Elastomerschicht 25 herum befindet sich eine flüssigkeitsdichte Hülse aus einem unter Temperatureinwirkung schrumpfenden Schlauch 26, der in Anlagebereichen auf dem Aktorkopf 22 und dem Aktorfuß 23 des Piezoaktors 21 dichtend anliegt. Außen ist hier sowohl im Anlagebereich am Aktorkopf 22 und am Aktorfuß 23 des Piezoaktors 21 ein Pressring 27 außen auf dem Schlauch 26 angeordnet.

Aus Figur 3 ist ein Beispiel zu entnehmen, bei dem hier der Anlagebereich am Aktorkopf 22 vergrößert dargestellt ist und bei dem ringförmig umlaufenden Erhöhungen 28 mit einem rechteckigen Querschnitt vorhanden sind. Nach einer Schrumpfung des Schlauchs 26 und dem Aufbringen der Pressringe 27 bilden sich durch plastische Verformungen im Schlauch 26 an den Erhöhungen 28 dichte und mechanisch feste Verbindungen zwischen dem Schlauch 26 und den Anlagebereichen am Aktorkopf 22 heraus, wie es in den vorangehenden Beschreibungsteilen erläutert worden ist. Die Erhöhungen 28 können dabei auch, wie in Figur 4 gezeigt, einen kegelförmigen Querschnitt aufweisen, wobei hier die Kegelspitzen der Erhöhungen 28 in den Schrumpfschlauch 26 hineinragen.

In Figur 5 ist ein weiteres Beispiel dargestellt, bei dem hier ringförmig umlaufende Vertiefungen 29 mit einem rechteckigen Querschnitt vorhanden sind. Nach einer Schrumpfung des Schlauchs 26 und dem Aufbringen des jeweiligen Pressrings 27 bilden sich auch hier die erwähnten, durch plastische Verformungen im Schlauch 26 verbesserten Dichtstellen an den Vertiefungen 29 heraus. Die Vertiefungen 29 können dabei auch, wie in Figur 6 gezeigt, einen kegelförmigen Querschnitt aufweisen.

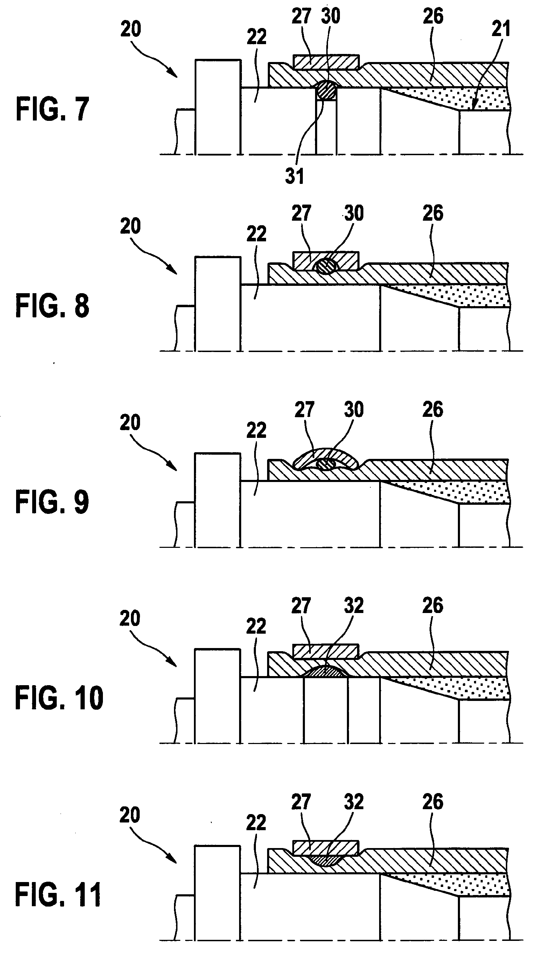

In Figur 7 ist ein erstes Ausführungsbeispiel des erfindungsgemäßen Aktormoduls 20 mit einem Piezoaktor 21 ausschnittsweise dargestellt, das bereits im Prinzip anhand der Figur 2 erläutert worden ist. Auch hier ist beispielhaft gezeigt, wie außen im Anlagebereich am Aktorkopf 22 der Pressring 27 außen auf dem schrumpfbaren Schlauch 26 angeordnet ist. Aus der Figur 7 ist jedoch ein Dichtring 30, beispielsweise ein Viton-O-Ring, zu entnehmen, der in eine ringförmige Vertiefung 31 eingelegt ist. Durch den ständigen Anpressdruck des Dichtrings 30 wird eine dauerhafte elastische Anpressung des Schlauchs 26 an den Pressring 27 auch für den Fall erreicht, dass der schrumpfbare Schlauch 26 fließen sollte. Durch die Anordnung des Dichtringes 30 in der Nut 31 kann das Aktormodul 20 radial sehr kleinbauend gefertigt werden.

Aus Figur 8 ist eine Anordnung des Dichtringes 30 in einer Nut des Pressringes 27 zu entnehmen. Bei diesem von außen wirkenden Dichtring 30 steht eine zusätzliche dichtende Wirkung nicht im Vordergrund, sondern es ist hier nur die zusätzliche federnde Anpresskraft auf den Schlauch 26 vorteilhaft. Ferner kann nach Figur 9 der Dichtring 30 auch in einer sich axial erstreckenden konvexen Wölbung des Pressrings 27 angeordnet sein.

Bei einer in Figur 10 und in Figur 11 gezeigten Ausführung ist ein Dichtring 32 vorhanden, der umlaufend auf dem Aktorkopf 22, wie hier in der Figur 10 dargestellt, und/oder auch auf den Aktorfuß bzw. auf den Pressring 27, wie in der Figur 11 gezeigt, aufvulkanisiert ist. Hierbei besteht der aufvulkanisierbare Dichtring 32 in vorteilhafter Weise aus einem vulkanisierbaren Elastomer und die Dichtwirkung im Anlagebereich des schrumpfbaren Schlauchs 26 ist hier mit erhöhter Sicherheit, in Verbesserung der Ausführungen nach den Figuren 7, 8 oder 9, gewährleistet, da eine Montage ohne O-Ring oder beschädigten O-Ring nicht möglich ist.

## Patentansprüche

1. Aktormodul mit einem Piezoaktor (3), der zwischen einem Aktorkopf (4) und einem Aktorfuß (5) angeordnete Piezoelemente (6) und eine Umhüllung aufweist, die aus einer mindestens die Piezoelemente (6) umgebenden Elastomerschicht und einer äußeren flüssigkeitsdichten, den Piezoaktor (3) und die Elastomerschicht umschließenden Hülse besteht, wobei die Hülse aus einem unter Temperatureinwirkung schrumpfenden Schlauch (26) gebildet ist, der in Anlagebereichen auf dem Aktorkopf (22) und/oder dem Aktorfuß (23) des Piezoaktors (21) dichtend anliegt und dass mindestens ein Pressring (27) außen auf dem Schlauch (26) angeordnet ist, der den Schlauch (26) auf die Anlagebereiche drückt, **dadurch gekennzeichnet,**
**dass** in mindestens einem Anlagebereich mindestens ein Dichtring (30) angeordnet ist, der umlaufend zwischen dem Schrumpfschlauch (26) und dem Aktorkopf (22) und/oder dem Aktorfuß (23) angeordnet ist und aus einem Material ist, dass die Dichtwirkung zwischen dem Schlauch (26) und dem Aktorkopf (22) und/oder dem Aktorfuß (23) erhöht, oder
**dass** in mindestens einem Anlagebereich mindestens ein Dichtring (30;32) angeordnet ist, der umlaufend zwischen dem jeweiligen Pressring (27) und dem Schlauch (26) angeordnet ist und aus einem Material ist, dass die Dichtwirkung zwischen dem Pressring (27) und dem Schlauch (26) erhöht.

2. Aktormodul nach Anspruch 1, **dadurch gekennzeichnet, dass** der Dichtring (30) in einer umlaufenden Vertiefung (31) am Aktorkopf (22) und/oder am Aktorfuß (23) angeordnet ist.

3. Aktormodul nach Anspruch 1, **dadurch gekennzeichnet, dass** der Dichtring (30) in einer umlaufenden Vertiefung am Pressring (27) angeordnet ist.

4. Aktormodul nach Anspruch 1, **dadurch gekennzeichnet, dass** der Dichtring (30) in einer sich axial erstreckenden konvexen Wölbung des Pressrings (27) angeordnet ist.

5. Aktormodul nach Anspruch 1, **dadurch gekennzeichnet, dass** der mindestens eine Dichtring (32) umlaufend auf dem Aktorkopf (22) und/oder dem Aktorfuß (23) aufvulkanisiert ist.

6. Aktormodul nach Anspruch 1, **dadurch gekennzeichnet, dass** der mindestens eine Dichtring (32) umlaufend innen auf dem Pressring (27) aufvulkanisiert ist.

7. Aktormodul nach Anspruch 5 oder 6, **dadurch gekennzeichnet, dass** der aufvulkanisierbare Dichtring (32) aus einem vulkanisierbaren Elastomer gebildet ist.

8. Aktormodul nach einem der vorhergehenden Ansprüche, **dadurch gekennzeichnet, dass** der Piezoaktor (21) Bestandteil eines Piezoinjektors für ein Einspritzsystem für Kraftstoff bei einem Verbrennungsmotor ist, wobei der Kraftstoff den schrumpfbaren Schlauch (26) umströmt.

## Claims

1. Actuator module with a piezo actuator (3) that has piezo elements (6), arranged between an actuator head (4) and an actuator foot (5), and a cladding, which consists of an elastomer layer, surrounding at least the piezo elements (6), and an outer, liquid-impermeable sleeve, enclosing the piezo actuator (3) and the elastomer layer, the sleeve being formed by a tube (26), which shrinks under the effect of temperature and lies in sealing contact in contact regions on the actuator head (22) and/or the actuator foot (23) of the piezo actuator (21), and at least one pressing ring (27), which presses the tube (26) onto the contact regions, being arranged on the outside on the tube (26), **characterized in that** in at least one contact region there is arranged at least one sealing ring (30) which is arranged peripherally between the shrink tube (26) and the actuator head (22) and/or the actuator foot (23) and is made of a material that increases the sealing effect between the tube (26) and the actuator head (22) and/or the actuator foot (23), or **in that** in at least one contact region there is arranged at least one sealing ring (30; 32) which is arranged peripherally between the respective pressing ring (27) and the tube (26) and is made of a material that increases the sealing effect between the pressing ring (27) and the tube (26).

2. Actuator module according to Claim 1, **characterized in that** the sealing ring (30) is arranged in a peripheral depression (31) on the actuator head (22) and/or on the actuator foot (23).

3. Actuator module according to Claim 1, **characterized in that** the sealing ring (30) is arranged in a peripheral depression on the pressing ring (27).

4. Actuator module according to Claim 1, **characterized in that** the sealing ring (30) is arranged in an axially extending convex bulge of the pressing ring (27).

5. Actuator module according to Claim 1, **characterized in that** the at least one sealing ring (32) is vulcanized peripherally on the actuator head (22) and/or the actuator foot (23).

6. Actuator module according to Claim 1, **characterized in that** the at least one sealing ring (32) is vulcanized peripherally on the inside on the pressing ring (27).

7. Actuator module according to Claim 5 or 6, **characterized in that** the sealing ring (32) that can be vulcanized on is formed from a vulcanizable elastomer.

8. Actuator module according to one of the preceding claims, **characterized in that** the piezo actuator (21) is a component part of a piezo injector for an injection system for fuel in an internal combustion engine, the fuel flowing around the shrinkable sleeve (26).

## Revendications

1. Module d'actionneur doté d'un piézoactionneur (3) qui présente des piézoéléments (6) disposés entre une tête d'actionneur (4) et un pied d'actionneur (5), une enveloppe constituée d'une couche d'élastomère qui entoure au moins les piézoéléments (6) et une douille extérieure, étanche aux liquides et entourant le piézoactionneur (3) et la couche d'élastomère,
la douille étant formée d'un manchon flexible (26) apte à se rétrécir sous l'effet de la température, qui repose de manière étanche dans les parties de pose sur la tête d'actionneur (22) et/ou sur le pied d'actionneur (23) du piézoactionneur (21), et
au moins une bague de compression (27) étant disposée à l'extérieur sur le manchon flexible (26) et repoussant le manchon flexible (26) sur les parties de pose,
**caractérisé en ce que**
dans au moins une partie de pose, au moins une bague d'étanchéité (30) est disposée périphériquement entre le tuyau flexible rétrécissable (26) et la tête d'actionneur (22) et/ou le pied d'actionneur (23) et est réalisée en un matériau qui augmente l'effet d'étanchéité entre le manchon flexible (26) et la tête d'actionneur (22) et/ou le pied d'actionneur (23) ou
**en ce que** dans au moins une partie de pose, au moins une bague d'étanchéité (30; 32) est disposée périphériquement entre la bague de compression (27) concernée et le manchon flexible (26) et est réalisée en un matériau qui augmente l'effet d'étanchéité entre la bague de compression (27) et le manchon flexible (26).

2. Module d'actionneur selon la revendication 1, **caractérisé en ce que** la bague d'étanchéité (30) est disposée dans un creux périphérique (31) sur la tête d'actionneur (22) et/ou sur le pied d'actionneur (23).

3. Module d'actionneur selon la revendication 1, **caractérisé en ce que** la bague d'étanchéité (30) est disposée dans un creux périphérique sur la bague de compression (27).

4. Module d'actionneur selon la revendication 1, **caractérisé en ce que** la bague d'étanchéité (30) est disposée dans un bombement convexe s'étendant axialement de la bague de compression (27).

5. Module d'actionneur selon la revendication 1, **caractérisé en ce que** la ou les bagues d'étanchéité (32) sont vulcanisées autour de la tête d'actionneur (22) et/ou du pied d'actionneur (23).

6. Module d'actionneur selon la revendication 1, **caractérisé en ce que** la ou les bagues d'étanchéité (32) sont vulcanisées périphériquement du côté intérieur sur la bague de compression (27).

7. Module d'actionneur selon les revendications 5 ou 6, **caractérisé en ce que** la bague d'étanchéité (32) vulcanisable est formée d'un élastomère vulcanisable.

8. Module d'actionneur selon l'une des revendications précédentes, **caractérisé en ce que** le piézoactionneur (21) fait partie d'un piézoinjecteur d'un système d'injection de carburant d'un moteur à combustion interne, le carburant s'écoulant autour du manchon flexible rétrécissable (26).
